# EUROPEAN PATENT APPLICATION

(11) **EP 0 921 569 A1**
(43) Date of publication of application: **09.06.1999**
(21) Application number: 98203726.9
(22) Date of filing: 06.11.1998
(51) Int. Cl.: H01L 25/10, H01L 25/065, H01L 23/498

(54) **Integrated circuit package**

(30) Priority: 06.11.1997 SG 9703963
(71) Applicant: TEXAS INSTRUMENTS INCORPORATED, Dallas, TX 75265 (US)
(72) Inventor: Eng, Kian Teng, Singapore 520332 (SG); Goh, Jine Sua, Singapore 669506 (SG)
(74) Representative: Holt, Michael

(57) **Abstract**

A high density integrated circuit package (30) including a substrate (70) having an opening (86) and first and second surfaces (92, 94), a plurality of routing strips (82) being integral with the substrate (70) and extending into the opening (86), a plurality of pads (100) disposed on the first and second surfaces (92, 94) and electrically connected with at least one of the routing strips (82), vias (84) electrically connecting the pads (100, 108) disposed on the first surface (92) with the pads (100) disposed on the second surface (94), a chip (50) adhered to the substrate (70) having bonding pads (120), wire bonding (80) electrically connecting at least one bonding pad (120) to at least one of the routing strips (82) and potting material (90) filling the opening (86) is disclosed.

## Description

### FIELD OF THE INVENTION

The present invention relates in general to the field of integrated circuit packages and more specifically to substantially flat, high density integrated circuit packages and a method for producing the same.

### BACKGROUND OF THE INVENTION

Without limiting the scope of the invention, its background is described in connection with integrated circuit packages, as an example.

Heretofore, in this field, integrated circuits have been formed on semiconductor wafers. The wafers are separated into individual chips and the individual chips are then handled and packaged. The packaging process is one of the most critical steps in the integrated circuit fabrication process, both from the point of view of cost and of reliability. Specifically, the packaging cost can easily exceed the cost of the integrated circuit chip and the majority of device failures are packaging related.

The integrated circuit must be packaged in a suitable media that will protect it in subsequent manufacturing steps and from the environment of its intended application. Wire bonding and encapsulation are the two main steps in the packaging process. Wire bonding connects the leads from the chip to the terminals of the package. The terminals allow the integrated circuit package to be connected to other components. Following wire bonding, encapsulation is employed to seal the surfaces from moisture and contamination and to protect the wire bonding and other components from corrosion and mechanical shock.

Conventionally, the packaging of integrated circuits has involved attaching an individual chip to a lead frame, where, following wire bonding and encapsulation, designated parts of the lead frame become the terminals of the package. The packaging of integrated circuits has also involved the placement of chips on a flexible board where, following adhesion of the chip to the surface of the flexible board and wire bonding, an encapsulant is placed over the chip and the adjacent flexible board to seal and protect the chip and other components.

Unfortunately, current methods for encapsulating silicon chips have led to various problems, including cracking between the encapsulation material and the integrated circuit components, as-well as high failure rates due to the multi-step nature of the process. Cracking has plagued the industry because of differences in the coefficient of thermal expansion of the different components, for example, between the soldering materials at the different interfaces and between metallic and non-metallic components. Cracking is also frequent between the silicon wafer and the encapsulation materials, usually epoxies, due to the extreme variations in temperature in various environments and between periods of operation and non-operation.

Even if the encapsulated silicon chip is successfully assembled into a working integrated circuit, another problem is commonly encountered. Once the silicon chip is encapsulated it is typically surface mounted using radiant heat or vapor saturated heating. This process, however, can lead to poor coplanarity due to uneven reflow, leading to integrated circuit failure.

Therefore, a need has arisen for a high density integrated circuit package and a process for producing a high density integrated circuit package. Also, a need has arisen for an integrated circuit module and a process for stacking integrated circuit packages together to produce an integrated circuit module. A need has also arisen for materials and methods that lead to increased yield by more closely matching the coefficient of thermal expansion of the materials used in the package. Further, a need has arisen for flat, high density, double sided integrated circuit package that provides protection to the silicon chip and wire bonding during subsequent manufacturing and testing steps and from the environment of its intended purpose.

### SUMMARY OF THE INVENTION

A device carrier for an integrated circuit package is disclosed herein. Also a a high density integrated circuit package and a process for producing a high density integrated circuit package that protects the components of the integrated circuit package during manufacturing and testing steps and from the environment of its intended purpose is disclosed herein. This disclosure also comprises an integrated circuit module and a process for producing an integrated circuit module that provides for the stacking of high density double sided integrated circuit packages.

The device carrier disclosed herein comprises a substrate having an opening and first and second surfaces. A plurality of routing strips extend into the opening. A plurality of pads are disposed adjacent the opening on the first surface. A plurality of pads may also be disposed adjacent the opening on the second surface. At least one of the pads disposed on the first surface or at least one of the pads disposed on the second surfaces are electrically connected with at least one of the routing strips. The device carrier also includes at least one via for electrically connecting the pads disposed on the first or second surface with routing strips. A region is also provided for a chip, having bonding pads disposed thereon, to be adhered to the substrate. In the integrated circuit package, wire bonding electrically connects the bonding pads to the routing strips. A potting material can then be disposed in the opening to provide protection to the wire bonding.

The high density integrated circuit package further includes bus bars that extend into the openings. The bus bar electrically connects at least one of the bonding pads of the chip to at least one the pads disposed on the first and the second surfaces of the substrate.

The high density integrated circuit package disclosed herein may also include solder balls electrically connected to the pads disposed on the surfaces of the substrate. An integrated circuit modules is formed by electrically connecting at least one of the pads disposed on the second surface of one high density integrated circuit package with at least one of the pads disposed on the first surface of another high density integrated circuit package. In one embodiment, solder balls are used to make the electrical connection between the integrated circuit packages. In another embodiment, columns are used to make the electrical connection between the integrated circuit packages.

The integrated circuit module may further include additional high density integrated circuit packages stackably and electrically connected together, for example, a third high density integrated circuit package may be stackably and electrically connected to the above-described integrated circuit module.

### BRIEF DESCRIPTION OF THE DRAWINGS

For a more complete understanding of the features and advantages disclosed herein, reference is now made to the detailed description along with the accompanying figures in which corresponding numerals in the different figures refer to corresponding parts and in which:
Figure 1 is a simplified end cross-sectional view of a high density integrated circuit package as disclosed herein;
Figure 2 is a simplified top view of the high density integrated circuit package of Figure 1;
Figure 3 is a simplified end cross-sectional view of an alternative high density integrated circuit package as disclosed herein;
Figure 4 is a simplified bottom view of an alternative high density integrated circuit package; and
Figure 5 is a simplified end cross-sectional view of a high density integrated circuit module having a plurality of high density integrated circuit packages oriented in a stacked configuration.

### DETAILED DESCRIPTION OF THE INVENTION

While the making and using of various embodiments of a high density integrated circuit package and a process for producing a high density integrated circuit package are discussed in detail below, it should be appreciated that the teachings disclosed herein provide many applicable inventive concepts which can be embodied in a wide variety of specific contexts. The specific embodiments discussed herein are merely illustrative of specific ways to make and use the package and process for producing the package and do not delimit the scope of the invention.

The teachings disclosed herein are generally related to high frequency integrated circuits using a high density board-on-chip design having a double sided substrate to achieve high speed performance and to meet the space constraint requirements of modern semiconductors. The teachings disclosed herein are also related to high frequency integrated circuits designed to enable a plurality of integrated circuit packages to be stacked together for high speed performance. The principles discussed may be incorporated into, for example, a synchronous DRAM (SDRAM) silicon chip. However, the teachings disclosed are also applicable to, for example, LOGIC, SRAM, EPROM and any other integrated circuit components.

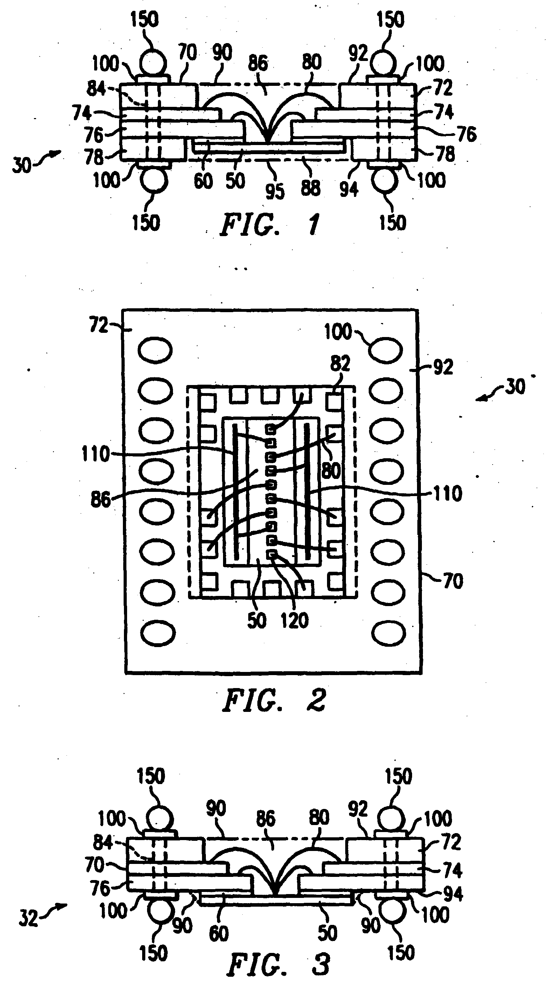

Figure 1 is a simplified cross-sectional view of an integrated circuit package that is generally designated 30. The integrated circuit package 30 comprises a silicon chip 50, which can be, for example, any integrated circuit component such as a DRAM, an EPROM, an SRAM or a LOGIC chip. A printed circuit board 70 is attached to the silicon chip 50 by an adhesive layer 60. The adhesive layer 60 may be made of, for example, a double-sided adhesive polyamide tape, adhesive glue or epoxy. The printed circuit board 70 consists of four layers, a top layer 72, a first intermediate layer 74, a second intermediate layer 76, and a bottom layer 78.

The printed circuit board 70 may be constructed from a material such as FR-4 which is available from, for example, Motorola Inc., U.S.A. FR-4 is an epoxy resin reinforced with a woven glass cloth. In selecting the material for the printed circuit board 70, one skilled in the art will recognize that four parameters should be considered, namely, thickness, dielectric constant, glass transition temperature and the coefficient of thermal expansion.

Thickness is dependant on the number of layers required and the amount of reinforcement used in a given layer. The reinforcing glass cloth can range in thickness from 2 mil per sheet (type 106) to about 8 mil per sheet (type 7628). Dielectric constant is determined by a combination of the resin used and the thickness and type of reinforcement used. Standard FR-4 has a dielectric constant of about 4.5. This constant can be reduced to about 3 by replacing the epoxy resin with a cyanate ester resin. The greater the thickness, however, the greater the problems associated with thickness control, rough surfaces, excessive drill reflection and poor resin refill.

The temperature at which a resin changes from a glass-like state into a "rubbery" state is generally designated as T_{g}. Standard FR-4 is made with a bifunctionally polymerizing epoxy that has a T_{g} of about 110 degrees C. Higher T_{g} temperatures, such as 125-150 degrees C may be withstood by using a tetrafunctional epoxy. For higher T_{g} values, in the range of 150 to 200 degrees C a cyanate ester:epoxy blend can be used. Additionally, polyimides provide for printed circuit boards having a T_{g} above 250 degrees C.

The coefficient of thermal expansion for FR-4 is about 16 ppm/degrees C. A difference in the coefficient of thermal expansion between the printed circuit board 70 made from FR-4 and the silicon chip 50 can lead to failure of the integrated circuit package 30 during, not only the assembly of the integrated circuit package 30, but also during the use of the integrated circuit package 30.

The adhesive layer 60 may be Hitachi HM122u. Alternatively, the silicon chip 50 can be adhered to the printed circuit board 70 with a die bonding film such as HIATTACH-335 (DF-335) manufactured by Hitachi Chemical Company of Tokyo, Japan. HIATTACH-335 (DF-335) is silver filled thermosetting type resin film for die-attaching. The bonding process generally involves attaching the film on the printed circuit board 70 at 160 degrees C for 5 seconds with an applied force of 1000-3000 grams; then attaching the silicon chip 50 on the film at 220 degrees C for 5 seconds under a force of 150-200 grams.
DF-335 has the following properties

| Test | Remarks | Units | DF-335 |
|---|---|---|---|
| Appearance | Visual | - | silver film |
| Solid Content | 200 degrees C-2h | wt% | ≥96 |
| Ash Content | 600 degres C-1.5h | wt% | 40 |
| Ash Content/ Solid | 600 degrees C-1.5h | wt%/solid | 42 |
| Thickness | Dial gauge | µm | 25 |
| Tensile Strength | R.T. | Kgf/mm² | 7.1 |
| Tensile Modulus | R.T. | kgf/mm² | 271 |
| Die shear strength | 4x4mm chip/Ag plated alloy | kgf/chip | |
| R.T. | 42 | | ≥10 |
| 250 | | | 0.9 |
| degrees C | | | |
| Peel strength 240 degrees C (after/ 85 degrees C 85%,48h) | 8x8mm chip alloy bare 42 | kgf/chip | ≥3.0 |
| Tg | TMA, 180·C-1h cured | Degrees C | 123 |
| Modulus | Viscoelastic spectrometer | Mpa | 1300 |
| Moisture | 85 degreesC/85%R H, 48h | wt% | 0.1 |

Other examples of adhesives include thermosetting adhesives, such as epoxies, polyimides and silicone. Thermoplastic adhesives that are hot-melted, in the form of sheets or as a pressure sensitive adhesive tape may also be used to adhere silicon chip 50 to the printed circuit board 70. Commonly used are adhesive tapes based on elastomers, silicones or acrylics because of their ease of use and easy incorporation into production.

Referring collectively to Figures 1 and 2, first intermediate layer 74 has routing strips 82 that are electrically connected through vias 84 to pads 100 located on top surface 92 of top layer 72 and bottom surface 94 of bottom layer 78. It should be understood by one skilled in the art that the terms "top" and "bottom" as well as the terms "side" and "end" are used for illustration purposes only, as the integrated circuit package 30 disclosed herein can be assembled and used in a variety of positions and ways.

Second intermediate layer 76 includes a pair of bus bars 110. The bus bars are electrically connected through vias 84 to one or more of the pads 100. The bus bars 110 may serve, for example, as power supplies or grounds, and it is preferred that one bus bar 110 serve one function, such as a power supply, and the second bus bar 110 serve another function, such as a ground.

The silicon chip 50 has bonding pads 120 located generally in the central area of silicon chip 50. The bonding pads 120 are connected to routing strips 82 and bus bars 110 by wire bonding 80. Solder balls 150 are located on pads 100 to allow integrated circuit package 30 to be attached to other components, such as another integrated circuit package 30, a motherboard or a single inline memory module.

Even though Figure 1 depicts printed circuit board 70 as having four layers 72, 74, 76 and 78, it should be understood by one skilled in the art that printed circuit board 70 may consist of a single layer or may be a multi-layered board having an alternate number of layers.

The above described components and their constructions and interrelation provide an assembly that is encapsulated as described below. The term "assembly" refers to the assembled components prior to encapsulation. The assembly consists of printed circuit board 70, adhered silicon chip 50 and wire bonding 80. The printed circuit board 70 has a top opening 86 and a cavity 88 with routing strips 82 and bus bars 110 extending into the top opening 86. The top opening 86 and the cavity 88 are open with respect to one another.

The wire bonding 80 process may begin after silicon chip 50 has been adhered to printed circuit board 70. Silicon chip 50 and printed circuit board 70 are then positioned on a heated pedestal to raise the temperature of the combination to a point between 100 degrees-300 degrees C. A gold wire having a diameter typically ranging from 0.7 mil. to 1.3 mil. is strung through a heated capillary where the temperature may range between 200 degrees-500 degrees C. A soldering ball is created at the end of the wire using either a flame or a spark technique. This soldering ball is then brought to bonding pad 120 on the silicon chip 50 and a combination of compression force and ultrasonic energy are used to create the desired metallurgical bond. Using this "stitch" technique significantly reduces the cross-section of the wire at that point. A loop is then created in the wire bonding 80 above the bond that has just been achieved, and the wire bonding 80 is routed to the desired connection on the printed circuit board 70 such as routing strip 82 or bus bar 110. The wire bonding 80 is clamped and the capillary raised, such that the wire bonding 80 will break free at the outer edge of the bond. This process is repeated until all the bonding pads 120 that require electrical connection on the silicon chip 50 are electrically connected to printed circuit board 70.

Following the assembly of the above-described components, top opening 86 is filled with potting material 90 as represented by the dashed line above top opening 86. Also, cavity 88 may be filled with potting material 80, as represented by the dashed line in cavity 88.

The potting material 90 may be a cyanate ester-type resin available from Shin-Etsu Chemical Co., Ltd., such as KMC 184VA and KMC 188VA-4. Other examples of potting materials that may be used with the teachings,disclosed herein include epoxies, polyesters, polyimides, cyanoacrylates, ceramic, silicone and urethane. The potting materials may also contain fillers that affect the coefficient of thermal expansion, as well as the strength and flexibility of the potting material. The selection of potting materials and fillers will depend on the components used to make the integrated circuit package 30, as will be known to those of skill in the art.

| Properties of Typical Potting Resins | | | | |
|---|---|---|---|---|
| | Epoxy | Polyester | Silicone | Urethane |
| Dielectric constant, D-150 | | | | |
| 60 Hz | 3.9 | 4.7 | 2.7 | 5.7 |
| 10⁶ Hz | 3.2 | --- | 2.7 | 3.4 |

| Dissipation factor, D-150 | | | | |
|---|---|---|---|---|
| 60 Hz | 0.04 | 0.017 | 0.001 | 0.123 |
| 10⁶ Hz | 0.03 | --- | 0.001 | 0.03 |
| Dielectric strength, D-149; V/mil | 450 | 325 | 550 | 400 |
| Volume resistivity, D-257; Ω cm | 10¹⁵ | 10¹⁴ | 10¹⁵ | 10¹³ |
| Arc resistance, D-495; seconds | 150 | 135 | 120 | 180 |
| Specific gravity, D-792 | 1.15 | 1.2 | 1.05 | 1.0 |
| Water absorption, D-570; % 24 h | 0.15 | 0.3 | 0.12 | 0.4 |
| Heat deflection temperature, D-648; at 264 lb/in², degrees F | 380 | 260 | < 70 | < 70 |
| Tensile strength, D-638; lb/in² | 9000 | 10,000 | 1000 | 2000 |
| Impact strength (Izod), D-256; ft · lb/in | 0.5 | 0.3 | No break | No break |
| Coefficient of thermal expansion, D-969; 10⁻⁵/degrees F | 5.5 | 7.5 | 4.0 | 15 |
| Thermal conductivity, C-177; Btu · in/(h·ft² degrees F) | 1.7 | 1.7 | 1.5 | |
| | | | | 1.5 |
| Linear shrinkage; % | 0.3 | 3.0 | 0.4 | 2.0 |
| Elongation, D-638; % | 3 | 3 | 175 | 300 |

The solder balls 150 used with the teachings disclosed herein may be attached to the pads 100 using conventional solder reflow systems. For example, a vapor phase solder reflow system may be used, which condenses vapor to surround the integrated circuit package 30 and the printed circuit board 70 with a cloud of steam. A liquid, such as a non-chlorinated (non CFC) fluorocarbon is first heated with enough energy to form a vapor and to sustain a vapor cloud. When the integrated circuit package 30 is then passed through the vapor, the vaporized liquid condenses thereon and gives off the latent heat of vaporization. This energy is then transferred to the integrated circuit package 30. As long as the integrated circuit package 30 remains in the vapor, the vapor continues to give off energy at a repeatable fixed rate and temperature, until the integrated circuit package 30 reaches the temperature of the vapor.

The advantage of using a non-chlorinated fluorocarbon is that it is extremely thermally stable, colorless, odorless and non-flammable. In addition, it has a low toxicity, low surface temperature, low boiling point, and low heat of vaporization. Because the fluid form of the non-chlorinated fluorocarbon is inert, it does not react with fluxes or component materials, nor does it absorb oxygen or other gases that cause reactions during the solder reflow. Most commercially available fluorocarbons used for vapor phase reflow are formulated to vaporize at precisely stable reflow temperatures for different solder materials, as will be known to those skilled in the art.

The vaporization temperature will depend on the solder type being used. A brief list of the preferred temperatures of non-chlorinated fluorocarbons that are used as vapor fluids is shown below in conjunction with the composition of the solder type to be used. In one embodiment the composition of the solder ball 150 is about 60% Pb (lead) and 40% Sn (tin), as this composition provides a strong adhesion between an integrated circuit packages 30 or between an integrated circuit package 30 and a board, such as a motherboard, sisterboard or SIMM board. Using the 60% Pb/40% Sn composition also dispenses with the need to provide solder paste on a solder pad, again due to the strong adhesion of the 60% Pb/40% Sn composition. Alternately, a variety of other materials may be used at solder balls 150, such as those described in the following chart.

| Vaporization Temperatures and Solder Types | |
|---|---|
| Fluid Temperature | Solder Type |
| 56, 80, 97, 101, 102 degrees C and 155 degrees C | 100 In |
| | 37 Sn/38 Pb/25 In |
| 165 degrees C | 70 Sn/18 Pn/12 In |
| | 70 In/30 Pb |
| 174 degrees C | 60 In/40 Pb |
| 190 degrees C | 90 In/10 Ag |
| | 50 In/50 Pb |
| | 63 Sn/37 Pb |
| | 70 Sn/30 Pb |
| | 60 Sn/40 Pb |
| 215 degrees C and 230 degrees C | 60 Sn/40 In |
| | 60 Sn/40 Pb |
| | 63 Sn/37 Pb |
| | 70 Sn/30 Pb |
| | 62 Sn/36 Pb/2 Ag |
| 240 degrees C and 253 degrees C | 75 Pb/25 In |
| | 81 Pb/19 In |
| 260 degrees C and 265 degrees C | 96.5 Sn/3.5 Ag |

Solder balls 150 may be attached to pads 100 by infrared or radiant heated solder reflow techniques. In such a system, each component of the soldering system is directly exposed to radiation from a heating element. Heat from the radiant energy element is absorbed by the different components according to its molecular structure.

Conventional radiant heat systems expose only the outer surfaces of the components to the radiant heat, which may not reach interior areas as efficiently as with vapor saturated heating methods as described above. The teachings disclosed herein, however, are not affected by this typical problem because of the use of solder balls 150 instead of leads. In fact, due to the reduced overall size either method, vapor phase solder reflow or radiant heated solder reflow, may be effectively used.

The teaching disclosed herein also solve other problems associated with solder reflow systems. These problems include the creation or failure due to voids, coplanarity, tombstoning, open joints, component cracking, thermal shock and thermal stressing. The teaching disclosed herein solve these problems because it dispenses with the need for electrically connecting soldering leads to the integrated circuit package 30. By using solder balls 150 instead of leads, the problems associated with voids around pad areas or under leads caused by incomplete reflow or poor welding of the soldering surface due to improper flux or badly oxidized surfaces is eliminated. The problems of coplanarity and tombstoning are also reduced or eliminated using the solder balls 150 because surface tension on both sides of the solder balls 150 is equal.

Open joints are usually caused by problems with coplanarity, while cracking may occur when trapped moisture within an integrated circuit package expands as the device is heated for reflow. The increase in internal pressure, causes the integrated circuit package to split open, usually at one of the corners. The splitting of the package causes wire bonding from the lead frame to the silicon chip to break and in some cases the silicon chips have cracked due to the warpage at the top of the package as the temperature differentials between the top and the bottom of the device cause different rates of expansion.

Using the teaching disclosed herein, the only surface temperature differential that occurs is between the solder ball 150 and the printed circuit board 70, which allows either vapor phase solder reflow or radiant heat solder reflow to be available. The small size of the solder balls 150, and of the integrated circuit package 130 as a whole, allows for any of the reflow systems to be used because the temperature differential between the components is almost negligible. Furthermore, by selecting a potting material 90 having a coefficient of thermal expansion similar, or equal to, the coefficient of thermal expansion of the other components of the integrated circuit package 30, heat reflow effects and problems can be minimized.

Although the board-on-chip layout of integrated circuit package 30 as depicted in Figures 1 and 2 has been described using centralized bonding pads 120, it should be understood by one skilled in the art that the principles disclosed herein are applicable to a silicon chip 50 with bonding pads 120 in alternate layouts such as positioned along the sides of the silicon chip 50.

Also, it should be noted by one skilled in the art that pads 100 and bus bars 110 may be located on a single layer of printed circuit board 70. Generally, a layer of insulated tape or coating may be placed on the bus bars 110 to provide for electrical isolation. The advantage of a multi-layer printed circuit board 70, however, is the elimination of the need to insulate the bus bars 110. The teachings disclosed herein dispose with the need for isolation. Additionally, the multi-layer printed circuit board 70 provides a greater process margin for wire bonding.

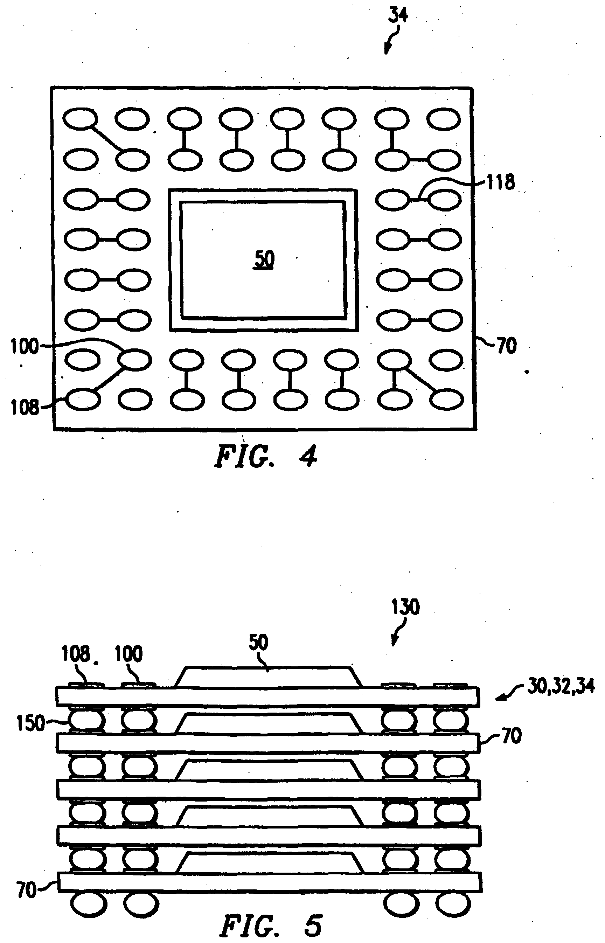

Figure 3 is a simplified cross-sectional view of another embodiment of the integrated circuit package disclosed herein that is generally designated 32. The integrated circuit package 32 comprises a silicon chip 50 and a printed circuit board 70 which is attached to the silicon chip 50 by an adhesive layer 60. In this embodiment, the printed circuit board 70 consists of three layers, a top layer 72, a first intermediate layer 74 and a bottom layer 76. The printed circuit board 70 has a top opening 86. As best seen in Figure 2, routing strips 82 and bus bars 110 extend into the top opening 86. After assembly, top opening 86 is filled with potting material 90 as represented by the dashed line above top opening 86 and around silicon chip 50. Vias 84 electrically connect pads 100 located on top surface 92 of top layer 72 and bottom surface 94 of bottom layer 78.

Figure 4 is a simplified bottom view of an alternative embodiment of an integrated circuit package that is generally designated 34. The integrated circuit package 34 has a printed circuit board 70 that is attached to a silicon chip 50 by an adhesive layer (not depicted). Disposed on printed circuit board 70 are two rows of pads 100 and 108 surrounding chip 50 on bottom surface 94 of printed circuit board 70. The first row of pads 100 is located adjacent to the silicon chip 50. The second row of pads 108 is located surrounding the first row of pads 100. Pads 100 may be electrically connected to pads 108 by conduit 118. The pads 108 may be electrically connected through (not depicted) to the pads 108 located on the opposite side of the printed circuit board 70 using vias.

In Figure 5, one embodiment of a three dimensional integrated circuit module is depicted in a simplified cross-sectional view and is generally designated 130. A silicon chip 50 is electrically connected to each printed circuit board 70 by means of wire bonding 80 followed by encapsulating the wire connections with a potting material 90. Each integrated circuit package 30, 32 or 34 is then interconnected with other integrated circuit packages 30, 32 or 34 using solder balls 150. Solder balls 150 replace the leads used to connect conventional integrated circuit packages to, for example, a motherboard. The use of solder balls 150 reduces the overall profile of the integrated circuit package 30, 32 or 34 and the integrated circuit module 130.

Even though Figure 5 depicts integrated circuit packages 30, 32 or 34 as being electrically connected together with solder balls 150, it should be noted by one skilled in the art that other electrical connection means may be used including, but not limited to, columns.

The teachings disclosed herein, therefore, allow for the stacking of integrated circuit packages 30, 32 or 34 into module 130 to achieve an overall reduction in height. It also allows for decreased failure due to the reduced number of soldered materials having varying coefficients of thermal expansion. The teachings disclosed herein further reduce the overall number of steps in the assembly of, for example, memory units by streamlining the assembly process not only in reduced number of steps, but also by elimination the curing steps associated with encapsulating integrated circuit.

Furthermore, the method disclosed herein takes advantage of the opening 86 at the center of the printed circuit board 70 for potting the wire bonding 80 that connect the silicon chip 50 and the printed circuit board 70 in a single step. By filling the opening 86 with potting material 90, the wire bonding 80 between silicon chip 50 and the printed circuit board 70 are generally protected from the environment and are particularly protected from moisture due to the hermetic nature of the encapsulation.

This means of potting the integrated circuit package 32 greatly reduces the overall profile by allowing the non-operative or backside of the silicon chip 50 to be exposed. By hermetically protecting the connections between the silicon chip 50 and the printed circuit board 70 at the top opening 86, there is no need to completely encapsulate the entire assembly.

Additionally, reduced environmental impact is obtained using the method and apparatus disclosed herein due to the overall decrease in the size of the integrated circuit package 30.

While this invention has been described in reference to certain illustrative embodiments, this description is not intended to be construed in a limiting sense. Various modifications and combinations of the illustrative embodiments, as well as other embodiments to the disclosed teaching, will be apparent to persons skilled in the art upon reference to the description.

## Claims

1. A device carrier comprising:
a substrate 70 having an opening 86, a first surface 92, a second surface 94, and a plurality of routing strips 82 extending into said opening 86;
a plurality of pads 100 disposed on said first surface 92 or said second surface 94;
one or more vias 84 arranged for electrically connecting at least one pad 100 with at least one routing strip 82;
a region 60 disposed adjacent said opening 86 for receiving a device 50.

2. The device carrier as claimed in Claim 1, wherein said routing strips 82 are formed integrally with said substrate 70.

3. The device carrier as claimed in Claim 1 or Claim 2, wherein one or more of said vias is arranged for electrically connecting at least one of said pads 100 disposed on said first surface 92 with at least one of said pads 100 disposed on said second surface 94.

4. The device carrier as claimed in any preceding claim, wherein said region for receiving said device 50 comprises an adhesive layer 60.

5. The device carrier as claimed in any preceding claim further comprising:
contact means 150 disposed on said pads 100 and arranged for electrical connecting said device carrier to at least one further device carrier.

6. An integrated circuit package comprising:
a device carrier comprising:
a substrate 70 having an opening 86, a first surface 92, a second surface 94, and a plurality of routing strips 82 extending into said opening 86;
a plurality of pads 100 disposed on said first surface 92 or said second surface 94;
one or more vias 84 arranged for electrically connecting at least one pad 100 with at least one routing strip 82;
a region 60 disposed adjacent said opening 86 for receiving a device 50;
a device 50 adhered to said region 60 having at least one bonding pad 120;
a plurality of wire bonds 80 for electrically connecting said at least one bonding pad 120 to at least one routing strip 82; and
potting material for substantially filling said opening 86.

7. The integrated circuit package as claimed in Claim 6, wherein said routing strips 82 are formed integrally with said substrate 70.

8. The integrated circuit package as claimed in Claim 6 or Claim 7, wherein one or more of said vias is arranged for electrically connecting at least one of said pads 100 disposed on said first surface 92 with at least one of said pads 100 disposed on said second surface 94.

9. The integrated circuit package as claimed in any of Claims 6 to 8, wherein said region for receiving said device 50 comprises an adhesive layer 60.

10. The integrated circuit package as claimed in any of Claims 6 to 9 further comprising:
contact means 150 disposed on at least one of said pads 100 and arranged for electrical connecting said device carrier to at least one further device carrier.

11. The integrated circuit package as claimed in any of Claims 6 to 10 further comprising:
at least one bus bar extending into said opening 86, said at least one bus bar being arranged for electrically connecting at least one pad 100 disposed on said first surface 92 with at least one pad 100 disposed on said second surface 94.

12. The integrated circuit package as claimed in any of Claims 6 to 11, wherein said at least one bus bar is formed integrally with said substrate 70.

13. The integrated circuit package as claimed in any of Claims 6 to 12, wherein said substrate 70 includes at least one cavity 88, said device 50 being adhered to said region 60 within said cavity 88.

14. An integrated circuit package module comprising:
first and second integrated circuit packages including:
a device carrier comprising:
a substrate 70 having an opening 86, a first surface 92, a second surface 94, and a plurality of routing strips 82 extending into said-opening 86;
a plurality of pads 100 disposed on said first surface 92 or said second surface 94;
one or more vias 84 arranged for electrically connecting at least one pad 100 with at least one routing strip 82;
a region 60 disposed adjacent said opening 86 for receiving a device 50;
a device 50 adhered to said region 60 having at least one bonding pad 120;
a plurality of wire bonds 80 for electrically connecting said at least one bonding pad 120 to at least one routing strip 82; and
potting material for substantially filling said opening 86;
said first integrated circuit package mounted such that said pads 100 on said first surface 92 or said second surface 94 thereof electrically contact said pads 100 on said first surface 92 or said second surface 94 of said second integrated circuit package thereby providing an electrical connection therebetween.

15. The integrated circuit package module as claimed in Claim 14, wherein said routing strips 82 are formed integrally with said substrate 70.

16. The integrated circuit package module as claimed in Claim 14 or Claim 15, wherein one or more of said vias is arranged for electrically connecting at least one of said pads 100 disposed on said first surface 92 with at least one of said pads 100 disposed on said second surface 94.

17. The integrated circuit package module as claimed in any of Claims 14 to 16, wherein said region for receiving said device 50 comprises an adhesive layer 60.

18. The integrated circuit package module as claimed in any of Claims 14 to 17 further comprising:
contact means 150 disposed on at least one of said pads 100 and arranged for electrical connecting said device carrier to at least one further device carrier.

19. The integrated circuit package module as claimed in any of Claims 14 to 18 further comprising:
at least one bus bar extending into said opening 86, said at least one bus bar being arranged for electrically connecting at least one pad 100 disposed on said first surface 92 with at least one pad 100 disposed on said second surface 94.

20. The integrated circuit package module as claimed in any of Claims 14 to 19, wherein said at least one bus bar is formed integrally with said substrate 70.

21. The integrated circuit package module as claimed in any of Claims 14 to 20, wherein said substrate 70 includes at least one cavity 88, said device 50 being adhered to said region 60 within said cavity 88.

22. The integrated circuit package module as claimed in any of Claims 14 to 21 further comprising:
a plurality of contact means 150 disposed between said pads 100 on said second surface of said first integrated circuit package and said pads 100 on said first surface of said second integrated circuit package.

23. The integrated circuit package module as claimed in any of Claims 14 to 22 further comprising:
a plurality of columns disposed between said second surface 94 of said first integrated circuit package and said first surface 92 of said second integrated circuit package.

24. The integrated circuit package module as claimed in any of Claims 14 to 23 further comprising:
a third integrated circuit package mounted such that said pads 100 on said first surface 92 or said second surface 94 thereof contact said pads 100 on said first surface 92 or said second surface 94 of said first or said second integrated circuit package thereby providing an electrical connection therebetween.

25. A method of forming an integrated circuit package comprising:
providing a device carrier comprising:
a substrate 70 having an opening 86, a first surface 92, a second surface 94, and a plurality of routing strips 82 extending into said opening 86;
a plurality of pads 100 disposed on said first surface 92 or said second surface 94;
one or more vias 84 arranged for electrically connecting at least one pad 100 with at least one routing strip 82;
a region 60 disposed adjacent said opening 86 for receiving a device 50;
adherring a device 50 to said region 60;
establishing a wire bond 80 between at least one bonding pad 120 and at least one routing strip 82 to provide an electrical connection therebetween; and
substantially filling said opening 86 with potting material.

26. The method as claimed in Claim 25 further comprising:
providing a plurality of contact means 150 between said pads 100 on said second surface of said first integrated circuit package and said pads 100 on said first surface of said second integrated circuit package.

27. The method as claimed Claim 25 or Claim 26 further comprising:
providing a plurality of columns between said second surface 94 of said first integrated circuit package and said first surface 92 of said second integrated circuit package.

28. A method of forming an integrated circuit package module comprising:
providing first and second integrated circuit packages including:
a device carrier comprising:
a substrate 70 having an opening 86, a first surface 92, a second surface 94, and a plurality of routing strips 82 extending into said opening 86;
a plurality of pads 100 disposed on said first surface 92 or said second surface 94;
one or more vias 84 arranged for electrically connecting at least one pad 100 with at least one routing strip 82;
a region 60 disposed adjacent said opening 86 for receiving a device 50;
adherring a device 50 to said region 60 having at least one bonding pad 120;
establishing a wire bond 80 between at least one bonding pad 120 and at least one routing strip 82 to provide an electrical connection therebetween;
substantially filling said opening 86 with potting material; and
mounting said first integrated circuit package such that said pads 100 on said first surface 92 or said second surface 94 thereof contact said pads 100 on said first surface 92 or said second surface 94 of said second integrated circuit package thereby providing an electrical connection therebetween.

29. The method as claimed in Claim 28 further comprising:
providing a plurality of contact means 150 between said pads 100 on said second surface of said first integrated circuit package and said pads 100 on said first surface of said second integrated circuit package.

30. The method as claimed in Claim 28 or Claim 29 further comprising:
providing a plurality of columns between said second surface 94 of said first integrated circuit package and said first surface 92 of said second integrated circuit package.

31. An integrated circuit module comprising:
a first integrated circuit package; and
a second integrated circuit package stackably and electrically connected to said first integrated circuit package.

32. A method of forming an integrated circuit module comprising:
providing a first integrated circuit package; and
stackably and electrically connecting a second integrated circuit package to said first integrated circuit package.
